# EUROPEAN PATENT SPECIFICATION

(11) **EP 2 466 633 B1**
(45) Date of publication and mention of the grant of the patent: **20.03.2019**
(21) Application number: 11178926.9
(22) Date of filing: 25.08.2011
(51) Int. Cl.: H01L 21/683, H01L 21/67, C23C 14/50, C23C 16/458, H02N 13/00

(54) **High efficiency electrostatic chuck assembly for semiconductor wafer processing**
Hocheffiziente elektrostatische Haltevorrichtung zur Verarbeitung von Halbleiterwafern
Mandrin électrostatique de haute efficacité pour le traitement de plaquettes semiconductrices

(30) Priority: 16.12.2010 US 423871 P; 19.08.2011 US 201113214152
(43) Date of publication of application: 20.06.2012
(73) Proprietor: Applied Materials, Inc., Santa Clara, CA 95054 (US)
(72) Inventor: Bhatnagar, Ashish, Fremont, California 94536 (US); Agarwal, Monika, Fremont, CA California 94555 (US); Gopalakrishnan, Padma, Fremont, California 94555 (US); Martin, Daniel, Cupertino, California 95014 (US)
(74) Representative: Conroy, John

(56) References cited:
- US-A- 5 916 689
- US-A1- 2002 109 955
- US-A1- 2005 045 106
- US-A1- 2009 141 418
- US-A1- 2009 199 765
- US-B1- 6 272 002
- PRANEVICIUS ET AL: "Structure and properties of deposits grown by ion-beam-activated vacuum deposition techniques", THIN SOLID FILMS, ELSEVIER-SEQUOIA S.A. LAUSANNE, CH, vol. 63, no. 1, 15 October 1979 (1979-10-15), pages 77-85, XP025843880, ISSN: 0040-6090, DOI: 10.1016/0040-6090(79)90103-2 [retrieved on 1979-10-15]

## Description

### BACKGROUND OF THE INVENTION

### Field of the Invention

Embodiments of the present invention generally relate to electrostatic chucks for holding a substrate in a processing environment.

### Description of the Related Art

In substrate processing applications, chucks are used to hold a substrate to prevent movement or misalignment of the substrate during processing. Electrostatic chucks use electrostatic attraction forces to hold a substrate in position. The use of electrostatic chucks has gained wide acceptance due to their advantages over mechanical and vacuum chucks, such as the reduction of stress related cracking in the substrate, the reduction of contamination in the processing chamber, and the ability to retain a substrate in a low vacuum environment.

A typical electrostatic chuck includes an electrically conductive electrode embedded within an electrical insulator. A voltage source electrically biases the substrate with respect to the electrode. The insulator prevents the flow of electrons therethrough, causing opposing electrostatic charges to accumulate in the substrate and in the electrode. Thus, an electrostatic force is generated to attract and hold the substrate onto the chuck.

A common electrostatic chuck is a multilayered structure fabricated using polyimide for the insulating layers sandwiching a copper electrode. Polyimide is a thermosetting material that has desirable properties such as high temperature stability (relative to other organic polymers), good dielectric behavior, and good mechanical properties. However, the use of polyimide to insulate the electrode limits the lifetime of the chuck in certain substrate fabrication processes. Polyimide and similar polymers have low erosion resistance for certain process gases and plasmas. Oxygen-containing gases and plasmas, which are used for a variety of substrate processing operations, are particularly detrimental to the polyimide layers on the electrostatic chuck. During these processes, the insulator can be eroded by the process gas and the resultant exposure of the electrode results in failure of the chuck during processing and loss of the entire substrate at a significant cost.

In addition, when a substrate breaks or chips to form fragments having sharp edges, the substrate fragments can easily puncture the polyimide film exposing the electrode of the chuck. Substrate fragments can also be transferred to the polyimide film from the substrate backside. Exposure of the electrode at even a single pinhole in the insulator can cause arcing between the electrode and plasma, and require replacement of the entire chuck.

Further, the process of manufacturing the aforementioned electrostatic chuck requires the use of pressure or heat sensitive adhesives as well as a laborious circuit buildup. For instance, a copper electrode circuit may be electroplated on a polyimide film. After forming the electrode, a second polyimide film layer may be adhered over the electrode layer using a pressure or heat sensitive adhesive. The multilayer stack is then adhered to the base of the chuck using a pressure or temperature sensitive phenol-type adhesive. This process is not only complicated, requiring many steps and extended fabrication time. Therefore, a need exists for an improved electrostatic chuck and a simplified method of manufacturing the same.

US 2009/0199765 A1 discloses a high efficiency electrostatic chuck for holding a substrate in a processing volume. The high efficiency electrostatic chuck includes an electrode embedded within a high purity, thermoplastic member. In particular, the high-purity, thermoplastic member may include a high-purity polyaryletherketone having an extremely low level of metallic ions present therein. The high-purity, polyaryletherketone has excellent wear resistance, high temperature resistance, plasma resistance, corrosive chemical resistance, electrical stability, and strength as compared to polyimide films used in electrostatic chucks. Is also provided a method of manufacturing said high efficiency electrostatic chuck.

PRAVENICIUS ET AL: "Structure and properties of deposits grown by ion-beam-activated vacuum deposition techniques", THIN SOLID FILMS, ELSEVIER-SEQUOIA S.A. Lausanne, CH, col. 63, no. 1, 15 October 1979, pages 77-85, discloses structures and properties of deposits formed by ion-beam-activated vacuum deposition techniques.

The invention relates to an electrostatic chuck assembly as described in claim 1.

### SUMMARY OF THE INVENTION

In one embodiment, an electrostatic chuck assembly comprising a flex stack having a preformed electrode embedded between a first dielectric layer and a second electric layer. The first dielectric layer may comprise a polyaryletherketone material. The polyaryletherketone first dielectric layer has an exposed substrate support surface. The second dielectric layer has an exposed bonding surface. In another embodiment, the electrostatic chuck assembly further comprises a pedestal bonded to the bonding surface of the second dielectric layer of the flex stack. The peel strength between the bonding surface and the pedestal is between about 0.91 kg per 2.54 cm [about 2 pounds per linear inch] and about 6.35 kg per 2.54 cm [about 14 pounds per linear inch].

In another embodiment, an electrostatic chuck assembly comprises a substrate support pedestal and flex stack bonded to the substrate support pedestal with an adhesive layer. The adhesive layer has a peel strength between about 0.91 kg per 2.54 cm [about 2 pounds per linear inch] and about 6.35 kg per 2.54 cm [about 14 pounds per linear inch]. The flex stack further comprises a first dielectric layer, a second dielectric layer and a preformed sheet electrode disposed between the first dielectric layer and the second dielectric layer. The first and second dielectric layers may be bonded thermoplastically or with adhesive. In another embodiment, the first dielectric layer is formed from polyaryletherketone. In still another embodiment, the first dielectric layer is formed from polyaryletherketone while the second dielectric layer is formed from polyimide.

In yet another embodiment, a method of fabricating an electrostatic chuck assembly comprises placing a preformed sheet electrode between a polyaryletherketone layer and a dielectric layer, bonding the polyaryletherketone layer and the dielectric layer together, plasma treating a surface of the dielectric layer, and bonding the plasma treated dielectric layer to a substrate support pedestal. The bond between the dielectric layer and the substrate support pedestal has a peel strength between about 0.91 kg per 2.54 cm [about 2 pounds per linear inch] and about 6.35 kg per 2.54 cm [about 14 pounds per linear inch].

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1A is a schematic, cross-sectional view of an embodiment of an electrostatic chuck assembly according to the present invention.
Figure 1B is an exploded, schematic, cross-sectional view of the electrostatic chuck assembly in Figure 1A.
Figure 1C is an enlarged, schematic, cross-sectional view of a portion of a substrate receiving surface of the electrostatic chuck in Figure 1A.
Figure 2 is a schematic, cross-sectional view of an exemplary processing chamber in which the electrostatic chuck assembly may be utilized.
Figure 3 is a schematic, top, plan view of an exemplary cluster tool in which the exemplary processing chamber may be utilized.

### DETAILED DESCRIPTION

The present invention generally provides a high efficiency electrostatic chuck assembly for holding a substrate in a processing volume. The high efficiency electrostatic chuck assembly includes a flex stack bonded to a substrate support pedestal. The flex stack includes an electrode disposed between two dielectric layers. In particular, at least the top or first dielectric layer of the flex stack may be polyaryletherketone, for example, as standard grade or a high purity grade which has an extremely low level of metallic ions present therein. Polyaryletherketone has excellent wear resistance, high temperature resistance, plasma resistance, corrosive chemical resistance, electrical stability, and strength as compared to polyimide or other polymer films currently used in electrostatic chucks. In addition, the flex stack may have a matte finish on a substrate support surface of the first dielectric layer to provide benefits such as improved temperature distribution across the surface of the electrostatic chuck. The non-substrate supporting side of the flex stack may be plasma treated to provide a desired surface finish, which is then bonded to the pedestal using an adhesive resulting in superior bonding strength and thermal conductivity compared to traditional polymer electrostatic chucks. The electrode of the electrostatic chuck may be a preformed sheet electrode, which enables more uniform thickness control, and thus, better chucking performance, along with increased ease of manufacturing.

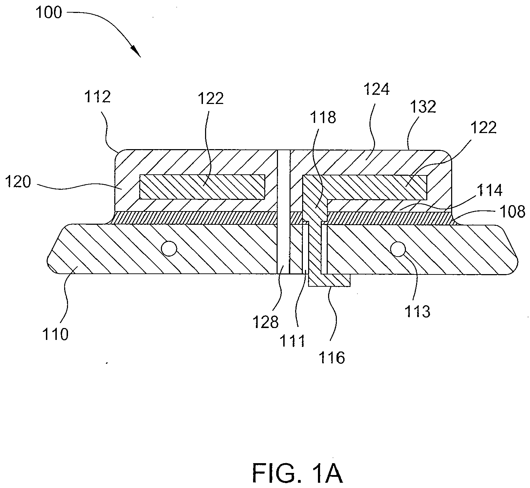

Figure 1A is a schematic, cross-sectional view of one embodiment of an electrostatic chuck assembly 100 according to the present invention. The electrostatic chuck assembly 100 includes at least a flex stack 112. The electrostatic chuck assembly 100 may also include a substrate support pedestal 110 bonded to the flex stack 112 using a layer of adhesive 108, such as an acrylic, epoxy, neoprene or other suitable adhesive. The flex stack 112 comprises a dielectric member 120 having an embedded electrode 122. The electrode 122 may be preformed or electro-deposited on one of the dielectric member 120. The electrode 122 may be preconfigured into various geometries, and may be monopolar or bipolar. The dielectric member 120 may include at least a first dielectric layer 124 and a second dielectric layer 114 having the electrode 122 disposed therebetween. In one embodiment, the first dielectric layer 124 is bonded to the substrate support pedestal 110 and having the electrode 122 disposed thereon. The second dielectric layer 114 is disposed atop the electrode 122 and the first dielectric layer 124. The first and second dielectric layers 124, 114 may be bonded together using an adhesive, thereby sandwiching the electrode 122 therebetween. Alternatively, the first and second dielectric layers 124, 114 may be bonded together thermoplastically to sandwich the electrode 122 therebetween.

Each of the first and second dielectric layers 124, 114 may have a thickness of between about 25µm to about 75µm. The thickness of each layer 124, 114 may be selective to optimize the thermal conductivity and chucking requirements for specific applications. The dielectric layers 124, 114 may each comprises a single layer of material, or optionally one or both of the dielectric layers 124, 114 may comprises a multiple layers of material.

The substrate support pedestal 110 may be a pedestal formed of a conventional material used in plasma processing chambers, such as aluminum or stainless steel. The substrate support pedestal 110 may include an opening 111 through which a conductive extension 116 may extend to furnish an electrical contact surface 118 through which power may be connected to the electrode 122. In one embodiment, the conductive extension 116 is an integral part of the electrode 122, i.e., the conductive extension 116 the electrode 122 are a singular, one piece component which minimizes the number of subcomponents, ensure robust electrical connectivity, reduces cost and simplifies assembly. The conductive extension 116 may be adhered to the bottom of the support pedestal 110. Alternatively, the conductive extension 116 may be separate from and brazed or otherwise electrically connected to the electrode 122. High voltage ranging from about 200 Volts to about 3,000 Volts may be applied to the electrode 122 to create polarization of the insulating dielectric films, creating static electricity on a substrate support surface 132 of the second dielectric layer 114, such that the substrate is attracted and held on the support pedestal 110 by the coulomb force of this static electricity. The substrate support pedestal 110 may include conduits 113 disposed therein through which a heat transfer fluid may flow to help control the temperature of the substrate.

To provide improved heat transfer with the substrate, which is held to the substrate support surface 132 of the first dielectric layer 124, a heat transfer gas may be fed to the surface of first dielectric layer 124 through a conduit 128. Conduit 128 may lead to gas directing channels (not shown) formed in the substrate support surface 132 of the first dielectric layer 124. The channels may take various geometrical forms. Heat transfer gas may be fed through conduit 128 to the gas directing channels during processing of the substrate.

The first dielectric layer 124 and the second dielectric layer 114 of the flex stack 112 may be fabricated from a dielectric film or sheet. In other embodiments, one or both of the first dielectric layer 124 and the second dielectric layer 114 of the flex stack 112 may be fabricated by spin deposition, spray deposition or other suitable deposition process. In one embodiment, one or both of the first dielectric layer 124 and the second dielectric layer 114 of the flex stack 112 may be formed from a high-purity, thermoplastic film, such as polyaryletherketone. The polyaryletherketone film used for the first dielectric layer 124 and/or the second dielectric layer 114 of the flex stack 112 may be a standard grade polyaryletherketone or a high-purity grade polyaryletherketone having an extremely low level of metallic ions present therein. In this context, high-purity is defined as having no greater than one part per million of each of the following metals: aluminum, antimony, arsenic, barium, beryllium, bismuth, boron, cadmium, calcium, chromium, cobalt, copper, gallium, germanium, hafnium, indium, iron, lead, lithium, mercury, magnesium, manganese, molybdenum, nickel, niobium, phosphorus, potassium, rubidium, scandium, selenium, silicon, silver, sodium, strontium, sulfur, tantalum, tellurium, thallium, tin, titanium, tungsten, vanadium, yttrium, zinc, and zirconium. In one embodiment, at least one of the first dielectric layer 124 and the second dielectric layer 114 is made of polyimide or other suitable thermoplastic film rather than high-purity polyaryletherketone. For example, the first dielectric layer 124 may be fabricated from high-purity polyaryletherketone while the second dielectric layer 114 may be fabricated from polyimide. In yet another embodiment, the first dielectric layer 124 comprises high-purity polyaryletherketone and is spin or spray deposited the electrode 122 and the second dielectric layer 114, wherein the second dielectric layer 114 is made of polyimide.

The flex stack 112 having at least the first dielectric layer 124 made of high-purity polyaryletherketone has excellent mechanical strength and puncture resistance as compared to traditional electrostatic chucks made of solely of polyimide films. As previously described, substrate particles may be transferred to the surface of flex stack 112 from the backside of the wafer or from wafer breakage. Puncture of the first dielectric layer 124 may result in arcing between the electrode 122 and the plasma in the chamber. Therefore, the use of high-purity polyaryletherketone for at least the first dielectric layer 124 significantly extends the life of the flex stack 112 by providing protection from substrate particle puncture.

Additionally, having the flex stack 112 at least partially made of high-purity polyaryletherketone has excellent high temperature resistance, such as processing environments having a temperature in excess of 200 degrees Celsius. The flex stack 112 made of high-purity polyaryletherketone also exhibits excellent chemical resistance to a wide range of chemical environments, including alkalis, aromatic hydrocarbons, alcohols, and hydrogenated hydrocarbons.

High-purity polyaryletherketone has excellent plasma resistance as well. For instance, a pre-clean etch plasma with 100 percent oxygen (O₂) gas may result in less than 0.14 g/cm² mass loss in 100 hours of plasma etch performed on a 10.3 cm² plaque. This characteristic allows the substrate support surface 132 of the flex stack 112 to be pretreated and cleaned to optimize chucking parameters without the need to open the chamber and expose the chamber to contaminants, as is required for cleaning a substrate support surface of an electrostatic chuck constructed of polyimide films.

High-purity polyaryletherketone is also resistant to a number of highly corrosive gases. For example, the flex stack 112 may be used in processing environments having corrosive gases, such as chlorine (Cl₂), boron trichloride (BCl₃), tetrafluoromethane (CF₄), and trifluoromethane (CHF₃), without the need for an additional protective covering. This characteristic allows the flex stack 112 to be used for extended time between chamber cleaning processes, resulting in greater system up time as compared to the use of electrostatic chucks constructed purely of polyimide films.

In embodiments where the first dielectric layer 124 is made from high-purity polyaryletherketone while second dielectric layer 114 is made of polyimide, the flex stack 112 enjoys the performance benefits of having polyaryletherketone exposed to the substrate and plasma for improved processing results and increased service life, while the polyimide material disposed between the substrate support pedestal 110 and electrode 122 provides cost savings and improved adhesion to the support pedestal 110.

The flex stack 112 of Figure 1A further benefits from use of high-purity polyaryletherketone in simplicity and ease of manufacturing as compared to traditional polyimide films. One advantage to using high-purity polyaryletherketone in forming at least one of the first dielectric layer 124 and the second dielectric layer 114 is due to the thermoplastic characteristics of the material, which, in some embodiments, facilitates the first dielectric layer 124 to be thermoplastically bonded to the second dielectric layer 114.

As discussed above, the electrode 122 may be preformed or electro-deposited on one of the dielectric member 120 and may be between about 5 µm and about 40 µm thick. One advantage of using a performed sheet for the electrode 122 is for ease of manufacture and reduced defects. For example, preformed electrodes 122 may be fabricated more uniformly and more easily inspected, such reducing the manufacturing cost and increasing quality. Additionally, electroplated copper circuits may have non-uniformities up to 22 percent and require seed layers, such as titanium seed layers) to be deposited on the dielectric member 120 prior to electrode formation. Such non-uniformities have a detrimental effect on the performance (i.e., holding force) of the completed electrostatic chuck. Additionally, portions of the seed layer not covered by the electrode 122 increase arcing potential. In contrast, using a preformed sheet for the electrode 122 provides very consistent thickness flex stack to flex stack, resulting in superior chuck to chuck performance uniformity as compared to conventional electrostatic chucks.

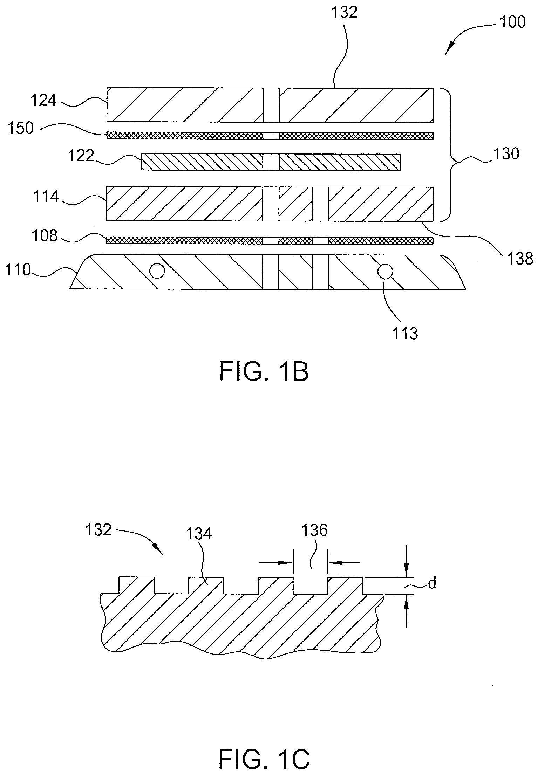

Figure 1B is an exploded, cross-sectional view of the chuck assembly 100. According one embodiment of the present invention, the electrode 122, such as a copper electrode, is preformed and embedded between the first dielectric layer 124 and the second dielectric layer 114 to create the flex stack 112. The electrode 122 may be a preformed conductive sheet (*i.e.,* film), for example a copper sheet. In one embodiment, the electrode 122 is a preformed conductive copper sheet electro-deposited on a release liner. Using a sheet for the electrode 122 results in an electrode having significantly greater thickness uniformity than can be achieved using an electroplated layer or wire mesh as used in conventional electrostatic chucks. Additionally, using a sheet for the electrode 122 allows for the electrode to have a thickness significantly greater than can be achieved using an electroplated layer. In one example, the electrode 122 may be formed from a copper sheet having a thickness selected between about 5 µm and about 40 µm. The thickness uniformity may be less than about 10 percent. As a result, the electrode 122 of the present invention provides more uniform substrate holding force across the electrostatic chuck assembly 100 due to the increased surface uniformity as compared to conventional electrostatic chucks of the prior art. In addition, arc resistance of the electrostatic chuck is improved as compared to prior art electrostatic chucks due to the increased flatness and thickness uniformity of the electrode 122. Further, by eliminating the electroplating steps of the prior art, the electrostatic chuck according to the present invention reduces the possibility of chamber contamination from materials used during the electroplating process, such as titanium or the like.

The electrode 122 may be bonded to the first and/or second dielectric layers 124, 114 of the flex stack 112. In one embodiment, the electrode 122 is directly fused to the second dielectric layer 114 of the flex stack 112 using heat and pressure. Directly fusing the electrode 122 the second dielectric layer 114 of the flex stack 112 eliminates the need of a copper seed layer disposed between the plated electrode and dielectric layer found on conventional electrostatic chuck assemblies when a preformed electrode 122 is utilized. Elimination of the copper seed layer reduces cost and manufacturing complexity, while resulting in a more robust bond that is less susceptible to delamination and defeats that could lead to poor performance.

An adhesive 150 is used to bond the first dielectric layer 124 to the second dielectric layer 114 to form the flex stack 112. As discussed above, the flex stack 112 may alternatively be heated and pressed to thermoplastically bond the first dielectric layer 124 to the second dielectric layer 114 to form the flex stack 112. In one embodiment, the adhesive 150 may be an acrylic, epoxy or a neoprene adhesive. In another embodiment, the adhesive 150 is an optically clear adhesive, for example, a clear acrylic adhesive. Other suitable optically clear adhesives may be utilized. The use of optically clear adhesive facilitates improved inspection for impurities and contaminates within the adhesive 150 which may contributed to poor bonding and/or poor heat transfer performance. Thus, the optically clear adhesive 150 provides a more robust electrostatic chuck assembly 100 with less chuck to chuck variation. Moreover, since the first dielectric layer 124 is transparent, the use of optically clear adhesive 150 allows for inspection of the electrode 122 after the layers 124, 114 of the flex stack 112 have been joined. In one embodiment, the adhesive 150 has a thickness of between about 0.5 to about 2.0 µm.

The substrate support surface 132 of the flex stack 112 may be treated, either before, during or after the bonding process, to provide a desired surface roughness or matte finish thereto. Alternatively, the substrate support surface 132 may have a glossy finish. Using a matte finish on the substrate support surface 132 of the flex stack 112 results in a number of benefits over conventional, polymer, electrostatic chucks. For instance, because peaks in the matte finish extend above the substrate support surface 132, a substrate is supported atop the peaks resulting in a reduced contact area with the substrate and allows for better temperature distribution of heat transfer gases from the conduit 128 across the surface of the substrate. In addition, the reduced contact area between the substrate and the substrate support surface 132 of the flex stack 112 results in less sensitivity to the substrate and/or processing conditions. For example, the flex stack 112 is less prone to abrasion and particle puncture than electrostatic chucks having conventional finishes. Figure 1C is a schematic, enlarged, cross-sectional view of the substrate support surface 132 of the flex stack 112. As seen in the Figure 1C, the substrate support surface 132 may have a plurality of peaks, or mesas 134 disposed there across. The mesas 134 extend upwardly from the substrate support surface 132 a distance (d) and are separated from one another by gaps 136.

A pedestal receiving surface 138 defined on the second dielectric layer 114 of the flex stack 112 may be treated to provide a desired surface finish to enhance the bond strength between the flex stack 112 and the support pedestal 110. In one example, the pedestal receiving surface 138 is treated by etching with plasma generated from an oxygen or corrosive gas (*e.g.,* O₂, CF₄). The plasma treatment provides a surface finish on the pedestal receiving surface 138 with increased surface area for bonding to the support pedestal 110. For example, plasma treatment has been found to increase the peaks in the pedestal receiving surface 138 by at least 200 percent per square micron. In addition, plasma treatment has been found to change the contour of the peaks in the pedestal receiving surface 138 to a more rounded contour. Both the increase in number of peaks and the increase in the rounded contour of the peaks on the pedestal receiving surface 138 increases adhesion to the support pedestal 110, whose surface roughness is maintained at less than 63 Ra. In fact, it has been found that treating the pedestal receiving surface 138 to the desired surface finish results in significant increase in bonding or peel strength between the flex stack 112 and the support pedestal 110 as subsequently described. It is contemplated that surface treatment may be accomplished using other techniques. It has also been found that plasma treating the surface results in removal of impurities, which further enhances the bond between the pedestal receiving surface of the second dielectric layer 114 and the support pedestal 110.

After treating the pedestal receiving surface 138, the flex stack 112 is bonded to the support pedestal 110 using the adhesive 108. In one example, the adhesive 108 is an acrylic, epoxy or a neoprene adhesive. In another embodiment, the adhesive 108 is an optically clear adhesive, for example, a clear acrylic adhesive. Other suitable optically clear adhesives may be utilized. The use of optically clear adhesive facilitates improved inspection for impurities and contaminates within the adhesive 108 which may contributed to poor bonding and/or poor heat transfer performance. Thus, the use of optically clear adhesives 108 provide a more robust electrostatic chuck assembly 100 with less chuck to chuck variation. Use of the adhesive 108, as opposed to the phenol types of adhesive traditionally used in electrostatic chuck bonding processes, allows the use of an increased thickness of adhesive resulting in increased bond or peel strength without sacrificing thermal conductivity, which is important for maintaining a uniform lateral temperature profile of the flex stack 112. For instance, the adhesive 108 may be used at a thickness between about 0.0127 mm [about 0.5 mm] and about 0.0254 mm [about 1 mm]. Additionally, it has been found that the combination of plasma treating the pedestal receiving surface 138 and using the adhesive 108 results in a peel strength between the substrate support pedestal 110 and the flex stack 112 that is an order of magnitude greater than that of conventional polymer electrostatic chucks. In one example, the peel strength between the flex stack 112 and the substrate support pedestal 110 is between about 0.91 kg per 2.54 cm [about 2 pounds per linear inch] and about 6.35 kg per 2.54 cm [about 14 pounds per linear inch].

Hence, the requirements of building up the electrode circuit and adhering the layers via pressure or heat sensitive adhesives are not required as when polyimide layers are used. Therefore, the process of manufacturing an embodiment of the flex stack 112 of the present invention may be simplified, providing a more reliable and repeatable chuck assembly while improving yield as compared with a traditional chuck assembly manufactured with polyimide films.

In addition, the process of refurbishing the chuck assembly 100 of the present invention may be significantly simplified as compared to conventional electrostatic chuck assemblies. In one embodiment, the used flex stack 112 is removed from the support pedestal 110 using a plasma process, such as an oxygen plasma process. The support pedestal 110 is then cleaned such as by one or more of treating with a corrosive gas or plasma, treating with an acidic solution, treating with a basic solution, bead blasting, or another conventional process for cleaning plasma process chamber parts. The top surface of the support pedestal 110 may be resurfaced by machining and adding a coating such as ceramic or conversion coating such as anodization to repair the top surface to receive a new flex stack 112. Next, the new flex stack 112 is prepared and surface treated as described above. The flex stack 112 is then bonded to the cleaned substrate support pedestal 110 using the adhesive 108 as described above.

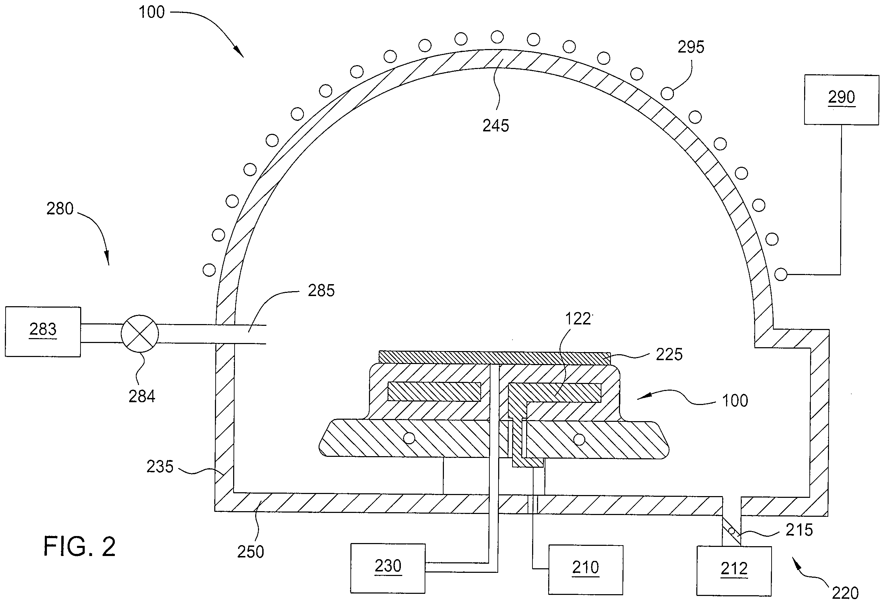

Figure 2 is a schematic, cross-sectional view of an exemplary processing chamber 200 in which the electrostatic chuck assembly 100 may be utilized. The exemplary processing chamber depicted may be suitable for plasma etching. However, the electrostatic chuck assembly 100 of the present invention may be used in other chambers performing other processes such as chemical vapor deposition, physical vapor deposition, and ion bombardment.

The processing chamber 200 generally has sidewalls 235, a ceiling 245, and a bottom 250, on which the electrostatic chuck assembly 100 may rest. The electrostatic chuck assembly 100 supports and retains a substrate 225, as previously described. Gas may be introduced into the processing chamber 200 by a gas supply 280 having a plurality of nozzles 285 that are fed from a process gas source 283. The gas flow through the nozzles 285 may be controlled by one or more gas valves 284. The gas may be energized to form a plasma by coupling electromagnetic energy, such as radio frequency (RF) or microwave energy, to the gas. In the processing chamber 200, shown in Figure 2, the gas may be energized inductively by applying an RF voltage from an antenna power supply 290 to an inductor antenna 295 adjacent the ceiling 245 of the processing chamber 200. Optionally, the gas may be energized capacitively by applying an RF voltage from an electrode voltage supply 210 to the electrode 122 of the electrostatic chuck assembly 100 and electrically grounding the facing ceiling 245. The temperature of the substrate 225 may be controlled through heat transfer gas supplied by a heat transfer gas source 230. Spent gas and byproducts may be exhausted from the processing chamber 200 through an exhaust system 220, which may include a vacuum pump 212 and a throttle valve 215.

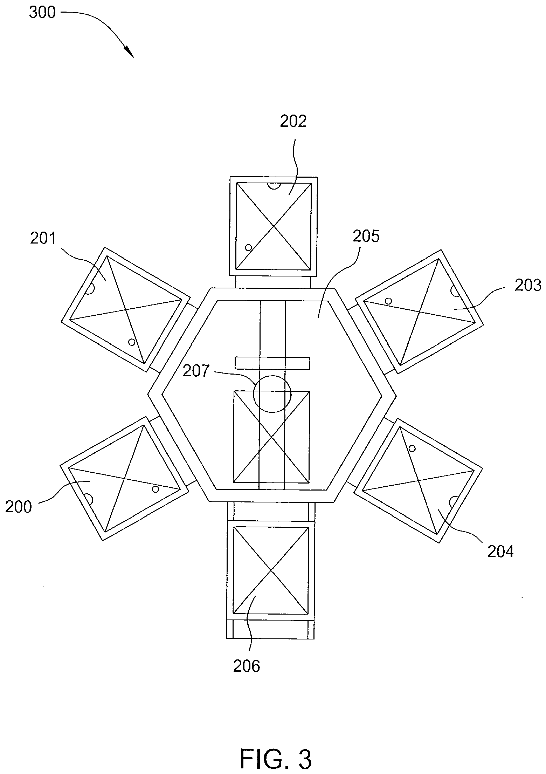

Figure 3 is a schematic, top, plan view of an exemplary cluster tool 300 in which the exemplary processing chamber 200 may be utilized. The processing chamber 200 may be attached to the cluster tool 300 that contains and provides electrical, plumbing, and other support functions for the processing chamber 200. The cluster tool 300 may have the capability of transferring a substrate 225 between its processing chambers 200-204 without breaking the vacuum and without exposing the substrate to moisture or other contaminants outside the cluster tool 300. The cluster tool 300 includes a transfer chamber 205 coupled to a load lock chamber 206 and the processing chambers 200-204. The load lock chamber 206 allows the substrate 225 to be transferred between the ambient environment outside the system and a vacuum environment within the transfer chamber 205 and processing chambers 200-204. The load lock chamber 206 may include one or more evacuatable regions holding one or more substrates 225. The evacuatable regions are pumped down during input of the substrate 225 into the cluster tool 300 and are vented during output of the substrate 225 from the cluster tool 300. The transfer chamber 205 may have a transfer robot 207 disposed therein adapted to transfer the substrate 225 between the load lock chamber 206 and the processing chambers 200-204. While five process chambers are shown in Figure 3, the cluster tool 300 may have any suitable number of process chambers.

In summary, a high efficiency electrostatic chuck assembly that includes a flex stack having a preformed electrode embedded between two layers of a high-purity, thermoplastic film is provided. In particular, at least the first dielectric layer compromising the substrate support surface is fabricated from a high-purity, thermoplastic film such as a high-purity polyaryletherketone having an extremely low level of metallic ions present therein. High-purity polyaryletherketone has excellent wear resistance, high temperature resistance, plasma resistance, corrosive chemical resistance, electrical stability, and strength as compared to polyimide or other polymer films currently used in electrostatic chucks. In addition, some embodiments of the flex stack may have a matte finish on the substrate support surface to provide benefits such as improved temperature distribution across the surface of the chuck. The non-substrate supporting or pedestal receiving side of the flex stack may be plasma treated to provide a desired surface finish, which is then bonded to a pedestal using an adhesive resulting in superior bonding strength compared to traditional polymer electrostatic chucks. An optional plate electrode may be utilized to simplify construction while improving temperature uniformity with less chuck-to-chuck variation.

While the foregoing is directed to embodiments of the present invention, other and further embodiments of the invention may be devised without departing from the basic scope thereof, and the scope thereof is determined by the claims that follow.

## Claims

1. An electrostatic chuck assembly (100), comprising:
a stack (112) comprising:
a first dielectric layer (124) comprising polyaryletherketone having a substrate support surface 132;
a second dielectric layer (114) having a plasma treated bonding surface (138), the first dielectric layer (124) bonded to the second dielectric layer (114); and
an electrode (122) disposed between the first dielectric layer (124) and the second dielectric layer (114); and
a pedestal (110) bonded to the plasma treated bonding surface (138) of the second dielectric layer (114), wherein a peel strength between the bonding surface (138) and the pedestal (110) is between about 0.91 kilogram per 2.54 cm [about 2 pounds per linear inch] and about 6.35 kilograms per linear 2.54 cm [about 14 pounds per linear inch].

2. The electrostatic chuck assembly (100) of claim 1, wherein the electrode (122) is a copper sheet having a thickness between about 5 µm and about 40 µm.

3. The electrostatic chuck assembly (100) of claim 1, wherein
the electrode (122) is electro-deposited between the first dielectric layer (124) and the second dielectric layer (114).

4. The electrostatic chuck assembly (100) of any one of claims 1-3 further comprising:
an adhesive layer (108) between about 0.0127 mm [about 0.5 mil] and about 0.0254 mm [about 1 mil] thick bonding the pedestal (110) to the bonding surface (138) of the second dielectric layer (114), wherein the adhesive layer comprises an acrylic or epoxy adhesive.

5. The electrostatic chuck assembly (100) of any one of claims 1-2, wherein the electrode (122) is fused to the second dielectric layer (114).

6. The electrostatic chuck assembly (100) of any one of claims 1-2 and 5, wherein the electrode (122) is a copper sheet having a thickness between about 4 µm and about 40 µm and a thickness uniformity of less than about 10 percent.

7. The electrostatic chuck assembly (100) of any one of claims 1-6, wherein the substrate support surface (132) of the first dielectric layer (124) has a matte finish and a second surface of the first dielectric layer (124) is bonded to the second dielectric layer (114).

8. The electrostatic chuck assembly (100) of any one of claims 1-7 further comprising:
an optically clear adhesive (150) bonding the first dielectric layer (124) to the second dielectric layer (114).

9. The electrostatic chuck assembly (100) of any one of claims 1-8, wherein the second dielectric layer (114) comprises polyimide and the first dielectric layer (124) comprises a standard grade or high purity grade polyaryletherketone.

10. The electrostatic chuck assembly (100) of any one of claims 1-9, wherein the polyaryletherketone comprises a high-purity polyaryletherketone material that includes no greater than one part per million of any one of aluminum, antimony, arsenic, barium, beryllium, bismuth, boron, cadmium, calcium, chromium, cobalt, copper, gallium, germanium, hafnium, indium, iron, lead, lithium, mercury, magnesium, manganese, molybdenum, nickel, niobium, phosphorus, potassium, rubidium, scandium, selenium, silicon, silver, sodium, strontium, sulfur, tantalum, tellurium, thallium, tin, titanium, tungsten, vanadium, yttrium, zinc, and zirconium.

11. The electrostatic chuck assembly (100) of any one of claims 1-10, wherein the second dielectric layer (114) is fabricated from polyimide.

12. The electrostatic chuck assembly (100) of any one of claims 1-11, wherein the first dielectric layer (124) is fabricated from spray deposited polyaryletherketone.

13. The electrostatic chuck assembly (100) of any one of claims 1-7 and 9-12, wherein the first dielectric layer (124) is thermoplastically bonded to the second dielectric layer (114).

14. A method of fabricating an electrostatic chuck assembly (100), comprising:
placing a preformed sheet electrode (122) between a polyaryletherketone layer (124) and a dielectric layer (114);
bonding the polyaryletherketone layer (124) and the dielectric layer (114) together to form a stack (122);
plasma treating a surface (138) of the dielectric layer (114); and
bonding the surface (138) of the dielectric layer (114) to a substrate support pedestal (110), the bond having a peel strength between about 0.91 kilogram per 2.54 cm [about 2 pounds per linear inch] and about 6.35 kilograms per linear 2.54 cm [about 14 pounds per linear inch].

## Patentansprüche

1. Elektrostatische Chuck-Baugruppe (100), die Folgendes umfasst:
einen Stapel (112), der Folgendes umfasst:
eine erste dielektrische Schicht (124), die Polyaryletherketon umfasst, mit einer Substratstützoberfläche 132;
eine zweite dielektrische Schicht (114) mit einer plasmabehandelten Bondoberfläche (138), wobei die erste dielektrische Schicht (124) an die zweite dielektrische Schicht (114) gebondet ist; und
eine Elektrode (122), die zwischen der ersten dielektrischen Schicht (124) und der zweiten dielektrischen Schicht (114) angeordnet ist; und
einen Sockel (110), der an die plasmabehandelte Bondoberfläche (138) der zweiten dielektrischen Schicht (114) gebondet ist, wobei eine Schälfestigkeit zwischen der Bondoberfläche (138) und dem Sockel (110) zwischen etwa 0,91 Kilogramm pro 2,54 cm [etwa 2 Pfund pro linearem Zoll] und etwa 6,35 Kilogramm pro linearen 2,54 cm [etwa 14 Pfund pro linearem Zoll] beträgt.

2. Elektrostatische Chuck-Baugruppe (100) nach Anspruch 1, wobei die Elektrode (122) ein Kupferblech mit einer Dicke zwischen etwa 5 µm und etwa 40 µm ist.

3. Elektrostatische Chuck-Baugruppe (100) nach Anspruch 1, wobei die Elektrode (122) zwischen der ersten dielektrischen Schicht (124) und der zweiten dielektrischen Schicht (114) elektrisch abgeschieden ist.

4. Elektrostatische Chuck-Baugruppe (100) nach einem der Ansprüche 1-3, die ferner Folgendes umfasst:
eine Haftschicht (108), die zwischen etwa 0,0127 mm [etwa 0,5 mil] und etwa 0,0254 mm [etwa 1 mil] dick ist und den Sockel (110) an die Bondoberfläche (138) der zweiten dielektrischen Schicht (114) bondet, wobei die Haftschicht einen Acryl- oder Epoxidklebstoff umfasst.

5. Elektrostatische Chuck-Baugruppe (100) nach einem der Ansprüche 1-2, wobei die Elektrode (122) mit der zweiten dielektrischen Schicht (114) verschmolzen ist.

6. Elektrostatische Chuck-Baugruppe (100) nach einem der Ansprüche 1-2 und 5, wobei die Elektrode (122) ein Kupferblech mit einer Dicke zwischen etwa 4 µm und etwa 40 µm und einer Dickengleichmäßigkeit von weniger als 10 Prozent ist.

7. Elektrostatische Chuck-Baugruppe (100) nach einem der Ansprüche 1-6, wobei die Substratstützoberfläche (132) der ersten dielektrischen Schicht (124) eine matte Oberflächenbehandlung aufweist und eine zweite Oberfläche der ersten dielektrischen Schicht (124) an die zweite dielektrische Schicht (114) gebondet ist.

8. Elektrostatische Chuck-Baugruppe (100) nach einem der Ansprüche 1-7, die ferner Folgendes umfasst:
einen optisch klaren Klebstoff (150), der die erste dielektrische Schicht (124) an die zweite dielektrische Schicht (114) bondet.

9. Elektrostatische Chuck-Baugruppe (100) nach einem der Ansprüche 1-8, wobei die zweite dielektrische Schicht (114) Polyimid umfasst und die erste dielektrische Schicht (124) ein Polyaryletherketon mit Standardgrad oder hohem Reinheitsgrad umfasst.

10. Elektrostatische Chuck-Baugruppe (100) nach einem der Ansprüche 1-9, wobei das Polyaryletherketon ein Polyaryletherketonmaterial mit hoher Reinheit umfasst, das nicht mehr als ein Teilchen pro Million von einem beliebigen von Aluminium, Antimon, Arsen, Barium, Beryllium, Bismut, Bor, Cadmium, Calcium, Chrom, Kobalt, Kupfer, Gallium, Germanium, Hafnium, Indium, Eisen, Blei, Lithium, Quecksilber, Magnesium, Mangan, Molybdän, Nickel, Niob, Phosphor, Kalium, Rubidium, Scandium, Selen, Silicium, Silber, Natrium, Strontium, Schwefel, Tantal, Tellur, Thallium, Zinn, Titan, Wolfram, Vanadium, Yttrium, Zink und Zirconium beinhaltet.

11. Elektrostatische Chuck-Baugruppe (100) nach einem der Ansprüche 1-10, wobei die zweite dielektrische Schicht (114) aus Polyimid gefertigt ist.

12. Elektrostatische Chuck-Baugruppe (100) nach einem der Ansprüche 1-11, wobei die erste dielektrische Schicht (124) aus durch Sprühablagerung gebildetem Polyaryletherketon gefertigt ist.

13. Elektrostatische Chuck-Baugruppe (100) nach einem der Ansprüche 1-7 und 9-12, wobei die erste dielektrische Schicht (124) thermoplastisch an die zweite dielektrische Schicht (114) gebondet ist.

14. Verfahren zum Fertigen einer elektrostatischen Chuck-Baugruppe (100), das Folgendes umfasst:
Platzieren einer vorgeformten Blechelektrode (122) zwischen einer Polyaryletherketonschicht (124) und einer dielektrischen Schicht (114);
Bonden der Polyaryletherketonschicht (124) und der dielektrischen Schicht (114) aneinander, um einen Stapel (122) zu bilden;
Plasmabehandeln einer Oberfläche (138) der dielektrischen Schicht (114); und
Bonden der Oberfläche (138) der dielektrischen Schicht (114) an einen Substratstützsockel (110), wobei die Bondung eine Schälfestigkeit zwischen etwa 0,91 Kilogramm pro 2,54 cm [etwa 2 Pfund pro linearem Zoll] und etwa 6,35 Kilogramm pro linearen 2,54 cm [etwa 14 Pfund pro linearem Zoll] aufweist.

## Revendications

1. Ensemble mandrin électrostatique (100) comprenant :
un empilement (112) comprenant :
une première couche diélectrique (124) comprenant une polyaryléthercétone ayant une surface de support de substrat (132) ;
une seconde couche diélectrique (114) ayant une surface de liaison traitée au plasma (138), la première couche diélectrique (124) étant liée à la seconde couche diélectrique (114) ; et
une électrode (122) disposée entre la première couche diélectrique (124) et la seconde couche diélectrique (114) ; et
un socle (110) lié à la surface de liaison traitée au plasma (138) de la seconde couche diélectrique (114), dans lequel une résistance au pelage entre la surface de liaison (138) et le socle (110) est comprise entre environ 0,91 kilogramme par 2,54 cm [environ 2 livres par pouce linéaire] et environ 6,35 kilogramme par 2,54 cm linéaire [environ 14 livres par pouce linéaire].

2. Ensemble mandrin électrostatique (100) selon la revendication 1, dans lequel l'électrode (122) est une feuille de cuivre ayant une épaisseur comprise entre environ 5 µm et environ 40 µm.

3. Ensemble mandrin électrostatique (100) selon la revendication 1, dans lequel l'électrode (122) est électrodéposée entre la première couche diélectrique (124) et la seconde couche diélectrique (114).

4. Ensemble mandrin électrostatique (100) selon l'une quelconque des revendications 1 à 3, comprenant en outre :
une couche adhésive (108) ayant une épaisseur comprise entre environ 0,0127 mm [environ 0,5 millième de pouce] et environ 0,0254 mm [environ 1 millième de pouce] liant le socle (110) à la surface de liaison (138) de la seconde couche diélectrique (114), dans lequel la couche adhésive comprend un adhésif acrylique ou époxy.

5. Ensemble mandrin électrostatique (100) selon l'une quelconque des revendications 1 et 2, dans lequel l'électrode (122) est fusionnée à la seconde couche diélectrique (114).

6. Ensemble mandrin électrostatique (100) selon l'une quelconque des revendications 1, 2 et 5, dans lequel l'électrode (122) est une feuille de cuivre ayant une épaisseur comprise entre environ 4 µm et environ 40 µm et une uniformité d'épaisseur de moins d'environ 10 pour cent.

7. Ensemble mandrin électrostatique (100) selon l'une quelconque des revendications 1 à 6, dans lequel la surface de support de substrat (132) de la première couche diélectrique (124) présente un fini mat et une seconde surface de la première couche diélectrique (124) est liée à la seconde couche diélectrique (114).

8. Ensemble mandrin électrostatique (100) selon l'une quelconque des revendications 1 à 7, comprenant en outre :
un adhésif optiquement transparent (150) liant la première couche diélectrique (124) à la seconde couche diélectrique (114).

9. Ensemble mandrin électrostatique (100) selon l'une quelconque des revendications 1 à 8, dans lequel la seconde couche diélectrique (114) comprend un polyimide et la première couche diélectrique (124) comprend une polyaryléthercétone de grade standard ou de grade de pureté élevé.

10. Ensemble mandrin électrostatique (100) selon l'une quelconque des revendications 1 à 9, dans lequel la polyaryléthercétone comprend un matériau de polyaryléthercétone de pureté élevée qui comprend une quantité inférieure ou égale à une partie par million d'un élément quelconque parmi l'aluminium, l'antimoine, l'arsenic, le baryum, le béryllium, le bismuth, le bore, le cadmium, le calcium, le chrome, le cobalt, le cuivre, le gallium, le germanium, le hafnium, l'indium, le fer, le plomb, le lithium, le mercure, le magnésium, le manganèse, le molybdène, le nickel, le niobium, le phosphore, le potassium, le rubidium, le scandium, le sélénium, le silicium, l'argent, le sodium, le strontium, le soufre, le tantale, le tellure, le thallium, l'étain, le titane, le tungstène, le vanadium, l'yttrium, le zinc et le zirconium.

11. Ensemble mandrin électrostatique (100) selon l'une quelconque des revendications 1 à 10, dans lequel la seconde couche diélectrique (114) est fabriquée à partir d'un polyimide.

12. Ensemble mandrin électrostatique (100) selon l'une quelconque des revendications 1 à 11, dans lequel la première couche diélectrique (124) est fabriquée à partir d'une polyaryléthercétone déposée par pulvérisation.

13. Ensemble mandrin électrostatique (100) selon l'une quelconque des revendications 1 à 7 et 9 à 12, dans lequel la première couche diélectrique (124) est liée de manière thermoplastique à la seconde couche diélectrique (114).

14. Procédé de fabrication d'un ensemble mandrin électrostatique (100), consistant :
à placer une électrode de feuille préformée (122) entre une couche de polyaryléthercétone (124) et une couche diélectrique (114) ;
à lier la couche de polyaryléthercétone (124) et la couche diélectrique (114) l'une à l'autre pour former un empilement (122) ;
à traiter au plasma une surface (138) de la couche diélectrique (114) ; et
à lier la surface (138) de la couche diélectrique (114) à un socle (110) de support de substrat, la liaison ayant une résistance au pelage comprise entre environ 0,91 kilogramme par 2,54 cm [environ 2 livres par pouce linéaire] et environ 6,35 kilogramme par 2,54 cm linéaire [environ 14 livres par pouce linéaire].
